# EUROPEAN PATENT APPLICATION

(11) **EP 2 738 287 A1**
(43) Date of publication of application: **04.06.2014**
(21) Application number: 13193809.4
(22) Date of filing: 21.11.2013
(51) Int. Cl.: C23C 16/40, C23C 16/44

(54) **Methof of fabricating zinc oxide thin film**

(30) Priority: 28.11.2012 KR 20120136263
(71) Applicant: Samsung Corning Precision Materials Co., Ltd., Gyeongsangbuk-do Gumi-si, 730-735 (KR)
(72) Inventor: Yoon, Gun Sang, 336-841 Asan-si ChungCheongNam-Do (KR); Kim, Seo Hyun, 336-841 Asan-si ChungCheongNam-Do (KR); Lee, Hyunhee, 336-841 Asan-si, ChungCheongNam-Do (KR); Yoo, Young Zo, 336-841 Asan-si ChungCheongNam-Do (KR)
(74) Representative: Gulde & Partner

(57) **Abstract**

A method of fabricating a zinc oxide (ZnO) thin film in which the surface shape of the ZnO thin film can be controlled during deposition of the ZnO thin film. The method includes depositing the ZnO thin film on a substrate by chemical vapor deposition (CVD). The CVD feeds an etching gas that etches the ZnO thin film concurrently with a source gas and an oxidizer gas, thereby controlling the surface shape of the ZnO thin film that is being deposited.

## Description

### CROSS REFERENCE TO RELATED APPLICATION

The present application claims priority from Korean Patent Application Number 10-2012-0136263 filed on November 28, 2012, the entire contents of which are incorporated herein for all purposes by this reference.

### BACKGROUND OF THE INVENTION

### Field of the Invention

The present invention relates to a method of fabricating a zinc oxide (ZnO) thin film, and more particularly, to a method of fabricating a ZnO thin film in which the surface shape of the ZnO thin film can be controlled during deposition of the ZnO thin film.

### Description of Related Art

Transparent conductive oxides such as indium tin oxide (ITO), zinc oxide (ZnO) and tin oxide (SnO₂) are widely used as a key material in a variety of products, such as flat panel displays, organic light-emitting displays and CIGS photovoltaic cells which are currently regarded as a big issue. Common properties that these products require for transparent conductive oxides include high transmittance, high electric conductivity and a flat surface shape. In particular, the flat surface shape prevents problems when a semiconductor device is formed on a transparent conductive oxide. In this way, the flat surface shape acts as an important element that is directly related to the yield of display panels.

In contrast, unlike the above-stated products, tandem-type photovoltaic cells, organic light-emitting diodes (OLEDs) for illumination and the like can have a higher efficiency when the surface of a transparent conductive oxide has a patterned textured structure or a random textured structure. This is because the textured surface structure increases the path of light so that the opportunity to absorb light is increased in photovoltaic cells and reduces total internal reflection of light so that more light is extracted to the outside in OLEDs for illumination.

At present, ITO is widely used in products which require a smooth surface shape, whereas ZnO or SnO₂ are widely used in products which require a textured surface shape. Among these materials, due to high price of ITO, many attempts have been made to find a substitute for ITO. Accordingly, ZnO having the advantages of high electrical conductivity and high transmittance is being developed for both the smooth surface and the textured surface.

Although the technique for manufacturing ZnO is being continuously developed, the surface shape is dependent on the deposition processing. In general, ZnO has a very smooth surface shape due to sputtering deposition, and a texture is formed on the surface of ZnO due to chemical vapor deposition (CVD). In some cases, etching is required in order to form a texture on the surface of ZnO by sputtering depending on characteristics required for a product. This, however, has the problem of increased cost. In addition, process optimization is required in order to form a ZnO thin film having a smooth surface shape by CVD.

The information disclosed in the Background of the Invention section is provided only for better understanding of the background of the invention, and should not be taken as an acknowledgment or any form of suggestion that this information forms a prior art that would already be known to a person skilled in the art.

### BRIEF SUMMARY OF THE INVENTION

Various aspects of the present invention provide a method of fabricating a zinc oxide (ZnO) thin film in which the surface shape of the ZnO thin film can be controlled during deposition of the ZnO thin film.

In an aspect of the present invention, provided is a method of fabricating a ZnO thin film that includes depositing the ZnO thin film on a substrate by chemical vapor deposition (CVD). The CVD feeds an etching gas that etches the ZnO thin film concurrently with a source gas and an oxidizer gas, thereby controlling the surface shape of the ZnO thin film that is being deposited.

According to an exemplary embodiment of the invention, the source gas may be composed of a mixture of diethylzinc and a hydrocarbon-based solvent, and the oxidizer gas may be composed of H₂O.

Here, the CVD may include feeding the source gas at 1.0 to 9.0 g/min and the oxidizer gas at 0.5 to 5.0 g/min.

The flow rate of the etching gas may be controlled in the range from 1 to 50 sccm.

The etching gas may be implemented as one selected from the group of fluorine-containing gases consisting of CF₄, C₂F₆, C₃F₆, C₃F₈ and NF₃.

The method may further include preheating the source gas and the oxidizer gas before feeding the source gas and the oxidizer gas into the process chamber where the CVD is carried out.

The CVD may include feeding the source gas and the oxidizer gas into the process chamber along different paths.

Each of the source gas and the oxidizer gas may be carried into the process chamber on a carrier gas that is composed of an inert gas.

In addition, the CVD may include controlling the substrate to pass through a zone where the etching gas is blown, at a velocity of 2 inch/min.

According to embodiments of the invention, it is possible to planarize the surface shape of the ZnO thin film or convert the surface shape of the ZnO thin film into a concave-convex structure through selective etching by concurrently feeding a source gas and an etching gas that are to form a zinc oxide thin film during a CVD process for deposition of a ZnO thin film and controlling the flow rate of the etching gas.

The methods and apparatuses of the present invention have other features and advantages which will be apparent from, or are set forth in greater detail in the accompanying drawings, which are incorporated herein, and in the following Detailed Description of the Invention, which together serve to explain certain principles of the present invention.

### BRIEF DESCRIPTION OF THE DRAWINGS

FIG. 1 to FIG. 5 are scanning electron microscopy (SEM) pictures of zinc oxide (ZnO) thin films fabricated according to Example 1 of the invention, showing the surface shapes of the ZnO thin films depending on the flow rate of an etching gas;

FIG. 6 is an X-ray diffraction (XRD) graph of a ZnO thin film fabricated by a method of fabricating a ZnO thin film according to Example 1 of the invention;

FIG. 7 is a graph showing variations in average roughness (Rms) depending on the flow rate of the etching gas in the ZnO thin film fabricated according to Example 1 of the invention; and

FIG. 8 to FIG. 10 are SEM pictures of ZnO thin films fabricated according to Example 2 of the invention, showing the surface shapes of the ZnO thin films depending on the flow rate of an etching gas.

### DETAILED DESCRIPTION OF THE INVENTION

Reference will now be made in detail to a method of fabricating a zinc oxide (ZnO) thin film according to the present invention, embodiments of which are illustrated in the accompanying drawings and described below, so that a person having ordinary skill in the art to which the present invention relates can easily put the present invention into practice.

Throughout this document, reference should be made to the drawings, in which the same reference numerals and signs are used throughout the different drawings to designate the same or similar components. In the following description of the present invention, detailed descriptions of known functions and components incorporated herein will be omitted when they may make the subject matter of the present invention unclear.

The method of fabricating a zinc oxide (ZnO) thin film according to the present invention deposits a ZnO thin film on a substrate by a chemical vapor deposition (CVD) process. Here, the CVD process uses a source gas in order to deposit the ZnO thin film. That is, the CVD process is adapted such that a metal source and an oxidizer in a gaseous state undergo a chemical reaction at a certain temperature and are attached to and deposited on a substrate.

Specifically, the CVD process according to an embodiment of the invention includes, first, loading a substrate into a process chamber and then heating the substrate to a certain temperature, for example, approximately 450°C. Here, the substrate can be implemented as a transparent glass substrate.

Afterwards, a source gas and an oxidizer gas that are to be deposited to form a ZnO thin film are blown into the process chamber. According to an embodiment of the invention, a mixture of diethylzinc (DEZn) and a hydrocarbon-based solvent is used as the source gas and H₂O vapor is used as the oxidizer gas. Here, in order to prevent the source gas and the oxidizer gas from prematurely mixing before entering the process chamber, it is preferable to control the supply of the source gas and the oxidizer gas along different paths. In addition, the source gas and the oxidizer gas can be heated before being supplied in order to activate a chemical reaction between the source gas and the oxidizer gas. The source gas and the oxidizer gas can be carried into the process chamber on carrier gases that are implemented as an inert gas such as nitrogen, helium or argon.

When the ZnO thin film that is fabricated according to an embodiment of the invention is applied, for example, for a transparent electrode of a photovoltaic cell, electrical conductivity must be ensured. For this, according to an embodiment of the invention, a variety of dopants can be injected into the ZnO thin film that is being deposited. Such a dopant substitutes for Zn or O in the internal lattice of ZnO, thereby improving electrical characteristics of ZnO.

According to an embodiment of the invention, as a scheme for controlling the surface shape of the ZnO thin film that is to be deposited, an etching gas that etches the ZnO thin film is concurrently fed with the source gas and the oxidizer gas that are blown into the process chamber in which the substrate is loaded for ZnO deposition. In this case, according to an embodiment of the invention, the substrate is controlled such that it passes, at a velocity of 2 inch/min, through a zone where these gases are blown.

Here, the flow rate of the etching gas is adjusted in the range from 1 to 50 sccm in the etching gas feed process. In addition, the flow rate of the source gas is adjusted in the range from 1.0 to 9.0 g/min, and the flow rate of the oxidizer gas is adjusted in the range from 0.5 to 5.0g/min. The flow rate of the etching gas can be adjusted while the flow rate of the source gas and the flow rate of the oxidizer gas are being fixed. For example, after the flow rate of the source gas is fixed at 5.5 g/min and the flow rate of the oxidizer gas is fixed at 0.8 g/min, the flow rate of the etching gas can be adjusted within the above-stated range.

As described above, the etching gas is fed together with the source gas and the oxidizer gas, and the flow rate of the etching gas is adjusted. This makes it possible to planarize the surface of the ZnO thin film or form the concave-convex structure, or the texture, on the surface of the ZnO thin film. Furthermore, the degree of planarization or texturing on the surface of the ZnO thin film can be controlled.

Here, the etching gas that is used to control the surface shape of the ZnO thin film is required neither to form a film nor to leave a precipitate through a reaction with the source gas, the oxidizer gas or the dopant. Thus, the etching gas must be implemented as a substance that does not react with the source gas, the oxidizer gas, the dopant, or the like. In addition, the etching gas must be made of a substance that can planarize the surface by selectively etching the surface concaves and convexes or convert the flat surface into the concave-convex structure through selective etching without changing the growth axis of ZnO that is being deposited. Therefore, according to an embodiment of the invention, the etching gas is implemented as one selected from among fluorine-containing gases consisting of CF₄, C₂F₆, C₃F₆, C₃F₈ and NF₃. The fluorine-containing gases are widely used as a dry etching gas for an indium tin oxide (ITO) or indium zinc oxide (IZO) thin film in semiconductor processes. The fluorine-containing gases are decomposed into F⁻ ions by plasma energy generated by a sputter or reactive ion etching (RIE) equipment to chemically react with a material that is to be etched. After this chemical reaction, halogen group compounds tend to easily break away from the etched material due to their high vapor pressure. According to an embodiment of the invention, the surface shape of the ZnO thin film that is being deposited is controlled using this characteristic of the fluorine-containing gases. When the etching gas selected from among the fluorine-containing gases is concurrently fed with the source gas, a reaction between the etching gas and the ZnO thin film that is being deposited can etch the portions of the ZnO thin film that are in the high energy state and unstable, thereby deforming the surface shape of the ZnO thin film.

### Example 1

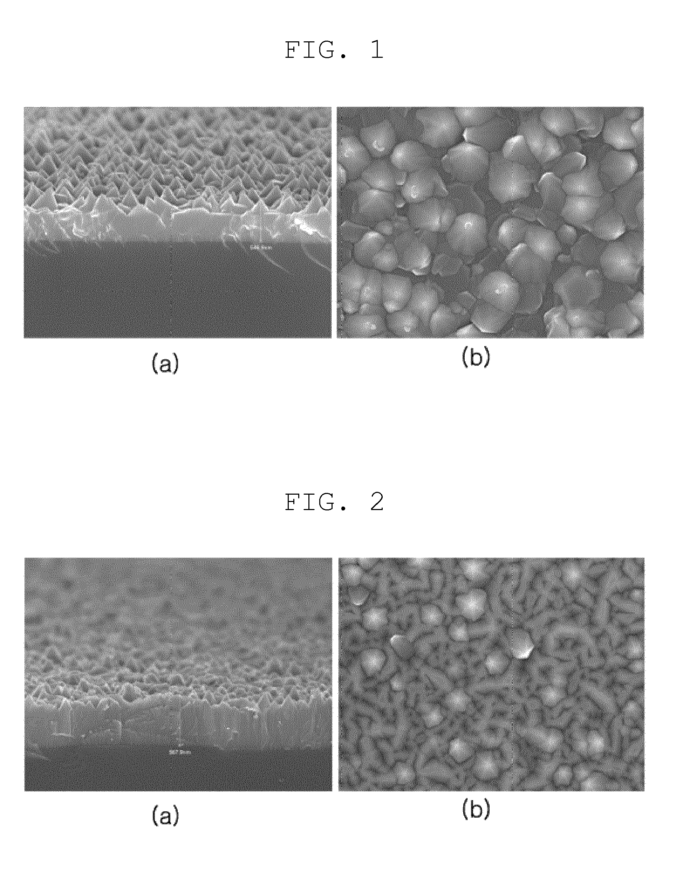

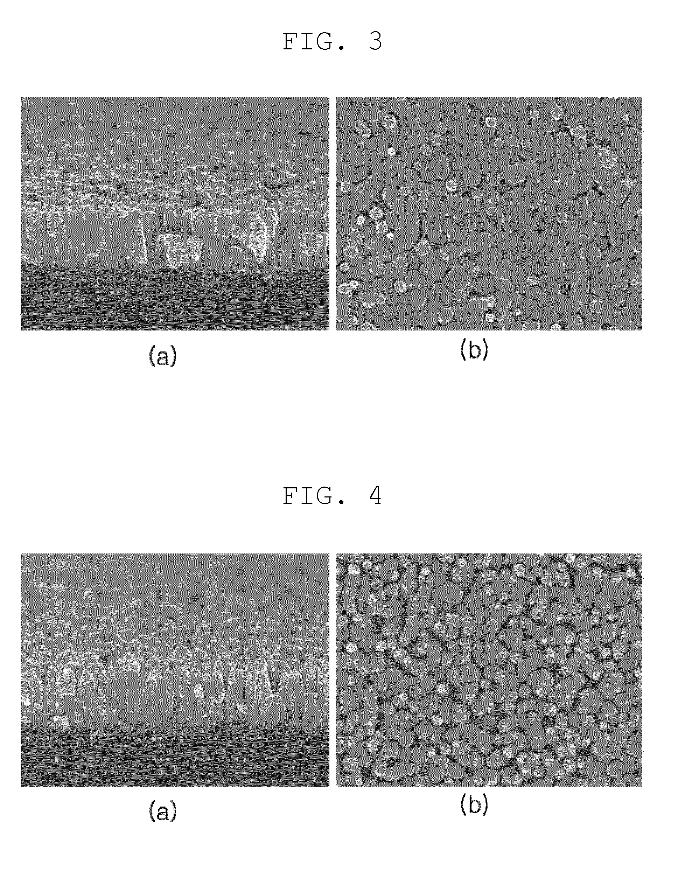

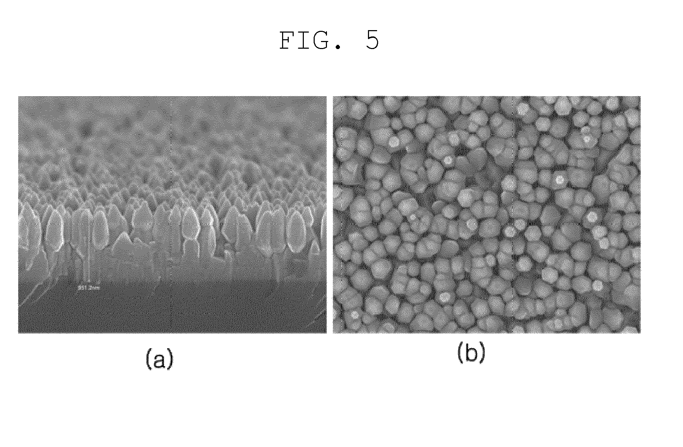

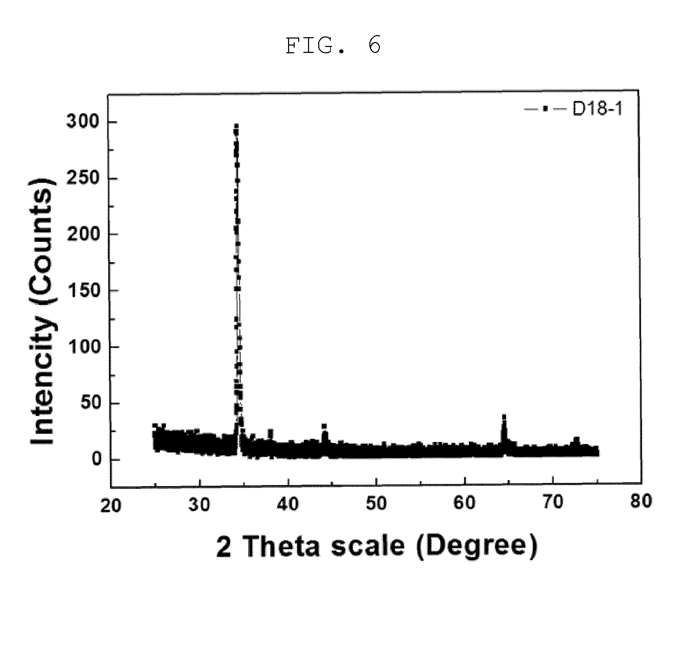

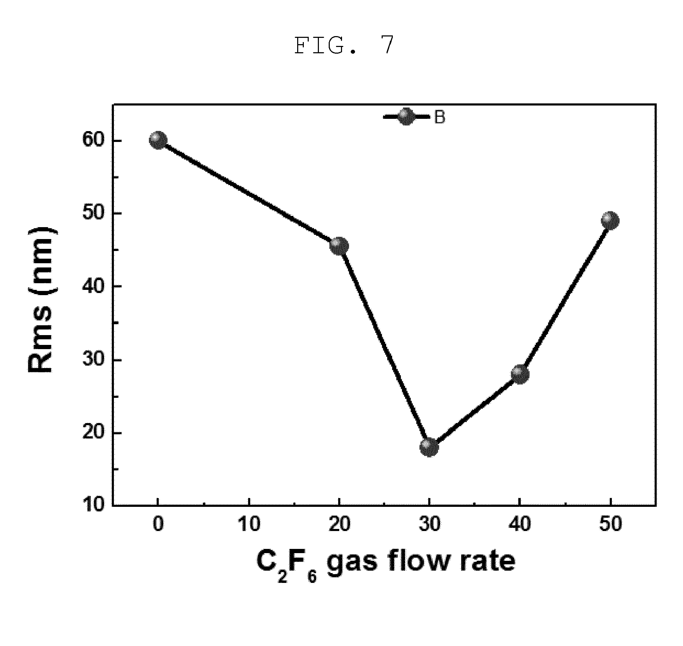

A glass substrate was loaded into a process chamber, and then was heated to a temperature of 450°C. A mixture of gaseous DEZn and a hydrocarbon-based solvent was fed at a flow rate of 5.5g/min and H₂O vapor was fed at a flow rate of 2.0g/min so that a ZnO thin film was deposited on the substrate, and C₂F₆ was concurrently fed at respective flow rates of 0 sccm (FIG. 1), 20 sccm (FIG. 2), 30 sccm (FIG. 3), 40 sccm (FIG. 4) and 50 sccm (FIG. 5). Afterwards, the surface shapes and the cross-sections of the deposited ZnO thin films were photographed using a field emission scanning electron microscope (FE-SEM), as shown in FIG. 1 to FIG. 5. The diffraction patterns were analyzed using an X-ray diffraction (XRD) instrument, as shown in FIG. 6. The surface roughness of either of the deposited ZnO thin films was measured using an atomic force microscope (AFM), as shown in FIG. 7.

Referring to these figures, it is noticeable that, while the grain size of the surface concave-convex structure of the ZnO thin film varies depending on the flow rate of C₂F₆, the end portion of the surface has a hexagonal shape and was grown along the c-axis of the (002) face (FIG. 6). Referring to FIG. 1 to FIG. 5, it is noticeable that surface etching was followed by grain boundary etching depending on the flow rate of the C₂F₆ gas. That is, it is noticeable that the C₂F₆ gas erodes the grain boundary that is highly unstable. In addition, the etching effect relatively increases with the increasing flow rate of the C₂F₆ gas, and the ZnO thin film was grown in the shape of a rod through side etching starting from the grain boundary. In addition, as shown in the graph of FIG. 7, when the C₂F₆ gas is fed, the surface concave-convex shape varies and the surface roughness changes depending on the flow rate of the C₂F₆ gas. The differences can be observed by AFM. When the flow rate of the C₂F₆ gas was 30 sccm, side grain boundary etching was performed. It is noticeable that the average roughness (Rms) reduced before that point and increased again after that point. Based on the above-discussed results, it is appreciated that the surface shape of the ZnO thin film can be controlled by feeding the etching gas and adjusting the flow rate of the etching gas.

### Example 2

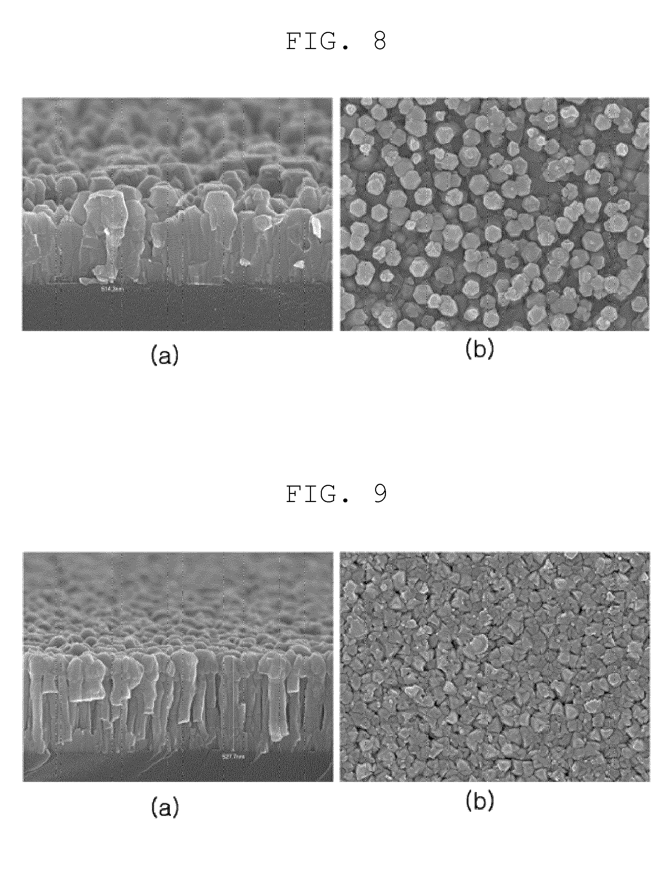

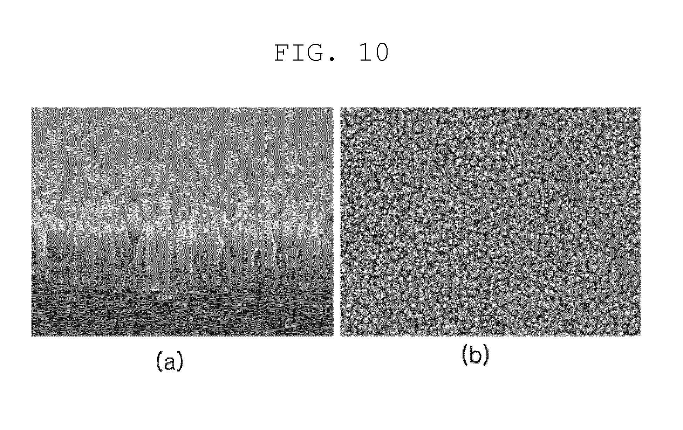

A glass substrate was loaded into a process chamber, and then was heated to a temperature of 450°C. A mixture of gaseous DEZn and a hydrocarbon-based solvent was fed at a flow rate of 5.5g/min, H₂O vapor was fed at a flow rate of 2.0g/min, and a mixture of tetramethylguanidine (TMG) and triethanolamine (TEA) was fed at a flow rate of 0.4 g/min so that a ZnO thin film was deposited on the substrate, and C₂F₆ was concurrently fed at respective flow rates of 5 sccm (FIG. 8), 10 sccm (FIG. 9) and 30 sccm (FIG. 10). Afterwards, the surface shapes and the cross-sections of the deposited ZnO thin films were photographed using the FE-SEM, as shown in FIG. 8 to FIG. 10.

Referring to FIG. 8 to FIG. 10, when TMG and TEA were added in order to improve electrical conductivity, the variations in the surface shape of the ZnO thin film depending on changes in the flow rate of C₂F₆ show a similar trend to Example 1. It can be appreciated that, when the dopant was added as in Example 2, the etching effect relatively increases with the increasing flow rate of the C₂F₆ gas, and the ZnO thin film was grown in the shape of a rod through side etching starting from the grain boundary.

The foregoing descriptions of specific exemplary embodiments of the present invention have been presented with respect to the drawings. They are not intended to be exhaustive or to limit the invention to the precise forms disclosed, and obviously many modifications and variations are possible for a person having ordinary skill in the art in light of the above teachings.

It is intended therefore that the scope of the invention not be limited to the foregoing embodiments, but be defined by the Claims appended hereto and their equivalents.

## Claims

1. A method of fabricating a zinc oxide thin film comprising depositing a zinc oxide thin film on a substrate by chemical vapor deposition, wherein the chemical vapor deposition comprises feeding an etching gas that etches the zinc oxide thin film concurrently with a source gas and an oxidizer gas, thereby controlling a surface shape of the zinc oxide thin film that is being deposited.

2. The method of claim 1, wherein the source gas comprises a mixture of diethylzinc (DEZn) and a hydrocarbon-based solvent, and the oxidizer gas comprises H₂O.

3. The method of claim 2, wherein the source gas is fed at 1.0 to 9.0 g/min and the oxidizer gas is fed at 0.5 to 5.0 g/min.

4. The method of claim 1, wherein a flow rate of the etching gas is controlled in a range from 1 to 50 sccm.

5. The method of claim 1, wherein the etching gas comprises one selected from the group of fluorine-containing gases consisting of CF₄, C₂F₆, C₃F₆, C₃F₈ and NF₃.

6. The method of claim 1, further comprising preheating the source gas and the oxidizer gas before feeding the source gas and the oxidizer gas into a process chamber where the chemical vapor deposition is carried out.

7. The method of claim 1, wherein the source gas and the oxidizer gas is fed along different paths into a process chamber where the chemical vapor deposition is carried out.

8. The method of claim 7, wherein each of the source gas and the oxidizer gas is carried into the process chamber on a carrier gas that comprises an inert gas.

9. The method of claim 1, wherein the chemical vapor deposition comprises controlling the substrate to pass through a zone where the etching gas is blown, at a velocity of 2 inch/min.
